# EUROPÄISCHE PATENTANMELDUNG

(11) **EP 2 251 912 A1**
(43) Veröffentlichungstag der Anmeldung: **17.11.2010**
(21) Anmeldenummer: 09006342.1
(22) Anmeldetag: 11.05.2009
(51) Int. Cl.: H01L 31/068, H01L 33/04, H01S 5/183, H01L 29/885

(54) **Tunneldioden aus spannungskompensierten Verbindungshalbleiterschichten**

(71) Anmelder: Fraunhofer-Gesellschaft zur Förderung der angewandten Forschung e.V., 80686 München (DE)
(72) Erfinder: Guter, Wolfgang, 79108 Freiburg (DE); Dimroth, Frank, 79115 Freiburg (DE); Schöne, Jan, 78479 Reichenau (DE)
(74) Vertreter: Pfenning, Meinig & Partner GbR

(57) **Zusammenfassung**

Die Erfindung bezieht sich auf Halbleiterbauteile, insbesondere Solarzellen aus III-V Verbindungshalbleitern, wie sie in terrestrischen PV Konzentratorsystemen oder zur elektrischen Energieversorgung in Satelliten eingesetzt werden. Sie findet jedoch auch Anwendung in anderen optoelektronischen Bauteilen, wie Laser und Leuchtdioden, wo entweder hohe Tunnelstromdichten nötig sind oder spezielle Materialien zum Einsatz kommen und wo eine Verspannung der Gesamtstruktur nicht erwünscht ist.
Die Erfindung besteht darin, Tunneldioden von Halbleiterbauteilen mit spannungskompensierten Halbleiterschichten vorzusehen.

## Beschreibung

Die Erfindung bezieht sich auf Halbleiterbauteile, insbesondere Solarzellen aus III-V Verbindungshalbleitern, wie sie in terrestrischen PV Konzentratorsystemen oder zur elektrischen Energieversorgung in Satelliten eingesetzt werden. Sie findet jedoch auch Anwendung in anderen optoelektronischen Bauteilen, wie Laser und Leuchtdioden, wo entweder hohe Tunnelstromdichten nötig sind oder spezielle Materialien zum Einsatz kommen und wo eine Verspannung der Gesamtstruktur nicht erwünscht ist.

### Stand der Technik

Mehrfachsolarzellen bestehen aus mehreren p-n-Übergängen aus verschiedenen Halbleitermaterialien mit abnehmender Bandlücke. Die verwendeten Halbleitermaterialien sind in der Regel III-V Verbindungshalbleiter, wie z.B. Galliumarsenid, und Elementarhalbleiter, wie Silizium oder Germanium. Es können jedoch auch II-VI Verbindungshalbleiter, wie Cadmiumtellurid, oder Mischhalbleiter, wie Silizium-Germanium (SiGe) verwendet werden. Mehrfachsolarzellen nutzen das Sonnenspektrum besser aus als Solarzellen mit nur einem p-n-Übergang und erzielen deshalb höchste Wirkungsgrade [Dimroth, F., High-Efficiency Solar Cells from III-V Compound Semiconductors, Physica Status Solidi C, 2006, 3(3): p. 373-9; Dimroth, F. and S. Kurtz, High-Efficiency Multifunction Solar Cells, MRS Bulletin, 2007, 32: p. 230-4]. Mit Tripelzellen wurden photoelektrische Umwandlungseffizienzen von über 40 % realisiert.

Die einzelnen Teilzellen von Mehrfachsolarzellen müssen elektrisch miteinander verbunden werden. Diese Verbindung sollte transparent sein und einen niedrigen elektrischen Widerstand aufweisen. Deshalb werden in heutigen Solarzellenstrukturen Interband-Tunneldioden eingesetzt. Durch den Tunneleffekt wird ein niedriger elektrischer Widerstand realisiert und durch geeignete Wahl der Halbleitermaterialien wird eine genügend hohe optische Transparenz gewährleistet [Bertness, K.A., D.J. Friedman, and J.M. Olson, Tunnel junction interconnects in GaAs-based multijunction solar cells, in Proceedings of the 24th Photovoltaic Specialists Conference, 1994, Waikoloa, Hawaii, USA; Takamoto, T., et al., Two-terminal monolithic In0.5Ga0.5P/GaAs tandem solar cells with a high conversion efficiency of over 30%, Japanese Journal of Applied Physics, 1997, 36 (10): p. 6215-20].

Für Bauteile aus mehreren verschiedenen Halbleiterschichten ist in der Regel eine gleichbleibende auf das Substrat angepasste Gitterkonstante für alle Schichten erforderlich, um Spannungen und Defekte in der Struktur zu minimieren.

Heute werden hocheffiziente Mehrfachsolarzellen aus III-V Verbindungshalbleitern typischerweise mittels metallorganischer Gasphasenepitaxie (MOVPE) auf Germanium (Ge) oder Galliumarsenid (GaAs) Substraten abgeschieden. Aber auch andere Verfahren, wie Molekülstrahlepitaxie werden verwendet. Die bekannteste Mehrfachsolarzelle enthält drei p-n-Übergängen bestehend aus den Verbindungshalbleitern Galliumindiumphosphid (GaInP), Galliumindiumarsenid (GaInAs) und Ge [Stan, M.A., et al. The Development of >28% Efficient Triple-Junction Space Solar Cells at Emcore Photovoltaics, in Technical Digest of the 3rd World Conference on Photovoltaic Energy Conversion, 2003, Osaka, Japan; Strobl, G., et al. Development and Qualification Status of European Triple Junction Solar Cells for Space Applications, in Proceedings of the 19th European Photovoltaic Solar Energy Conference, 2004, Paris, France; Baur, C., et al., Triple Junction III- V based Concentrator Solar Cells: Perspectives and Challenges. Transactions of the ASME. Journal of Solar Energy Engineering, 2006, 129(3): p. 258-65]. Eine solche Struktur kann das Sonnenspektrum aufgrund der unterschiedlichen Bandlücken der verwendeten Halbleitermaterialien deutlich effizienter ausnutzen als beispielsweise Solarzellen aus Silizium [Dimroth, F., High-Efficiency Solar Cells from III-V Compound Semiconductors, Physica Status Solidi C, 2006, 3(3): p. 373-9]. Entscheidend für die hohen Wirkungsgrade, mit denen diese Solarzellen das Sonnenlicht in elektrische Energie umwandeln, ist die hohe Kristallqualität der verwendeten Halbleiterschichten. Kristalldefekte in den Schichten bilden meist Rekombinationszentren für die photoelektrisch generierten Ladungsträger und reduzieren den Wirkungsgrad der Solarzelle. Solche Defekte können vermieden werden, wenn alle verwendeten Halbleitermaterialien dieselbe Gitterkonstante aufweisen. Dies ist bei der Tripelsolarzelle mit Teilzellen aus Ga_{0.5}In_{0.5}P, Ga_{0.99}Inc_{0.01}As und Ge möglich. Alle Schichten können etwa mit der Gitterkonstante von Ge auf dem Ge-Substrat abgeschieden werden.

Die Kombination der Teilsolarzellen aus Ga_{0.5}In_{0.5}P, Ga_{0.99}In_{0.01}As und Ge ist jedoch noch nicht optimal an das Sonnenspektrum angepasst. Wünschenswert sind Materialien mit etwas geringeren Bandlückenenergien. Dies kann beispielsweise erreicht werden, indem der GaInP und der GaInAs Teilzelle mehr Indium (In Gehalt zwischen 5 und 17% [King, R.R., et al., 40% efficient metamorphic GaInP/GaInAs/Ge multijunction solar cells. Applied Physics Letters, 2007. 90: p. 183516-1 -3; Fetzer, C. M., et al., High-Efflciency Metamorphic GaInP/GaInAs/Ge Solar Cells Grown by MOVPE. Journal of Crystal Growth, 2004, 261 (2-3): p. 341-8; Dimroth, F., et al., Metamorphic GayIn1-yP/Ga1-xInxAs Tandem Solar Cells for Space and for Terrestrial Concentrator Applications at C > 1000 Suns. Progress in Photovoltaics: Research and Applications, 2001. 9(3): p. 165-1 78]) beigemischt wird. Solche Veränderungen in der Komposition der Halbleitermaterialien beeinflussen jedoch meist nicht nur deren Bandlücke, sondern auch deren Gitterkonstante [Levinshtein, M., S. Rumyantsev, and M. Shur, Ternary and Quaternary III-V Compounds. Handbook Series on Semiconductor Parameters. Vol. 2. 1999, Singapore: World Scientific Publishing Co. Pte. Ltd.]. Wird also beispielsweise die besser ans Sonnenspektrum angepasste Kombination einer Ga_{0.35}In_{0.55}P und Ga_{0.8}In_{0.17}As Teilsolarzelle auf dem Ge-Substrat abgeschieden, so haben diese Schichten eine etwa 1 % größere Gitterkonstante als das Germanium. Dies führt zur Bildung von Kristalldefekten und zu niedrigen Wirkungsgraden. Deshalb wird in sogenannten Pufferstrukturen zwischen Substrat und den gitterfehlangepassten Teilsolarzellen die Gitterkonstante kontinuierlich oder graduell verändert. Dabei ist es möglich, die Kristalldefekte sehr gut in diesen Pufferstrukturen zu lokalisieren [Schöne, J., et al., Misfit Dislocation Blocking by Dilute Nitride Intermediate Layers. Applied Physics Letters, 2008. 92(8): p. 081905; Geisz, J.F., et al., 40.8% efficient inverted triple-junction solar cell with two independently metamorphic junctions. Applied Physics Letters, 2008. 93(12): p. 123505/1 -3]. Gelingt es, dass nur sehr wenige Defekte bis in die photoaktiven Schichten der Teilzellen reichen (< 10⁶ cm⁻³), können ebenfalls sehr hohe Wirkungsgrade realisiert werden [King, R.R., et al., 40% efficient metamorphic GaInP/GaInAs/Ge multijunction solar cells. Applied Physics Letters, 2007. 90: p. 183516-1 -3 8].

Die Anwendung hocheffizienter III-V Mehrfachsolarzellen liegt heute zum einen in der Energieversorgung von Satelliten und Sonden im Weltraum [King, R.R., et al. Advanced III-V Multijunction Cell for Space. in Proceedings of the 4th World Conference on Photovoltaic Energy Conversion. 2006. Waikoloa, Hawaii, USA; Meusel, M., et al. Development and Production of European III-V Multi-Junction Solar Cells. In Proceedings of the 22nd European Photovoltaic Solar Energy Conference and Exhibition. 2007, Milan, Italy], und zum anderen in terrestrischen PV Konzentratorsystemen [Bett, A.W. and H. Lerchenmueller, The FLATCON® System from Concentrix Solar, in Concentrator Photovoltaics. 2007, Springer-Verlag GmbH. p. 301-1 9; Lerchenmueller, H., et al. from FLATCON® Pilot Systems to the first Power Plant. in Proceedings of the International Conference on Solar Concentrators for the Generation of Electricity or Hydrogen. 2007. EI Escorial, Spain].

Die Teilsolarzellen von Mehrfachsolarzellen werden typischerweise durch Tunneldioden elektrisch miteinander verbunden. Diese Dioden bestehen vorwiegend aus bis zur Entartung dotierten Halbeiterschichten [Esaki, L., Discovery of the tunnel diode. IEEE Transactions on Electron Devices, 1976. ED-23(7): p. 644-7] und werden neben der Photovoltaik vor allem auch in der Hochfrequenztechnik und der Optoelektronik eingesetzt. In Leuchtdioden (LEDs) und Laserdioden (z.B. VCSELs) werden Tunneldioden beispielsweise eingesetzt, um die Polarität des Materials zu ändern. Durch ändern der Polarität von p auf n können aufgrund der höheren Ladungsträgermobilität Widerstandsverluste und Inhomogene Verteilung des Stromflusses reduziert werden [Manish Mehta, et al., Electrical Design Optimization of Single-Mode Tunnel-Junction-Based Long-Wavelength VCSELs. IEEE JOURNAL OF QUANTUM ELECTRONICS, 2006. 42(7): p. 675; Seong-Ran Jeon, et al., GaN-Based Light-Emitting Diodes Using Tunnel Junctions. IEEE JOURNAL OF SELECTED TOPICS IN QUANTUM ELECTRONICS, 2002. 8(4): p. 739]. Außerdem ist die freie Ladungsträgerabsorption von n-Material meist geringer als in p-Material. Somit werden auch optische Verluste reduziert [Manish Mehta, et al., Electrical Design Optimization of Single-Mode Tunnel-Junction-Based Long-Wavelength VCSELs. IEEE JOURNAL OF QUANTUM ELECTRONICS, 2006. 42(7): p. 675; Edmond, J.A., et al., Blue Light-Emitting Diode with Degenerate Junction Structure. 1994, Cree Research, Inc., Durham, N.C., US 1,252,84]. Analog zu Mehrfachsolarzellen werden in Kaskadenlasern die einzelnen Kavitäten ebenfalls mit Tunneldioden verbunden [W.J. Siskaninetz, et al., Reduced power consumption in GaAsbased bipolar cascade lasers. IEEE Electronic Letters, 2002, 38(21): p. 1259]. Bei VCSELs wird entweder durch Oxide oder mittels Tunneldioden eine optische und elektrische Apertur für höhere Leistungsdichten geschaffen [A. Bachmann, et al., Continuous-wave Operation of electrically pumped GaSb-based vertical cavity surface emitting laser at 2.3 mm. IEEE Electronic Letters, 2008. 44(3): p. 202].

Die Verwendung von Tunneldioden als Verbindungselement ist so attraktiv, weil sie den hohen Anforderungen bezüglich elektrischer und optischer Eigenschaften genügen können. Um auch unter hochkonzentriertem Licht in Konzentratorsystemen die hohen Photoströme zu transportieren, muss der elektrische Widerstand der Tunneldiode sehr gering sein. Ein hoher elektrischer Widerstand, wie ihn beispielsweise eine normale p-n-Diode aufweist, führt zu hohen Verlusten. Für die Tunneldiode müssen deshalb hohe Tunnelstromdichten erreicht werden, was vor allem durch sehr hoch dotierte Halbleiter mit kleiner Bandlücke realisiert wird. Außerdem sollte die Tunneldiode kein Licht absorbieren, das in darunter liegenden Teilzellen noch zur photoelektrischen Energiekonversion genutzt wird. Dies wird durch dünne Schichten aus indirekten oder hochbandlückigen Halbleitermaterialien erreicht [Takamoto, T., et al., Mechanism of Zn and Si diffusion from a highly doped tunnel junction for InGaP/GaAs tandem solar cells. Journal of Applied Physics, 1999. 85(3): p. 1481-6]. Die Epitaxie von hochdotierten III-V Verbindungshalbleitern wurde von zahlreichen Forschungsgruppen weltweit untersucht [Scheffer, F., et al., High doping performance of lattice matched GaInP on GaAs. Journal of Crystal Growth, 1992. 124 (1-4): p. 475-82; Keiper, D., R. Westphalen, and G. Landgren, Comparison of carbon doping of InGaAs and GaAs by CBr4 using hydrogen or nitrogen as carrier gas in LP-MOVPE. Journal of Crystal Growth, 1999, 197(1-2): p. 25-30; Bettini, J., et al., Analysis of Be doping of InGaP lattice matched to GaAs. Journal of Crystal Growth, 2000, 208(1-4): p. 65-72; Dimroth, F. et al., High C-Doping of MOVPE Grown Thin AlxGa1-xAs Layers for AlGaAs/GaAs Interband Tunneling Devices. Journal of Electronic Materials, 2000, 29(1): p. 47-52; Mimila Arroyo, J., et al., Carbon acceptor doping efficiency in GaAs grown by metalorganic chemical vapor deposition. Applied Physics Letters, 2001, 79(19): p. 3095-7]. Die Tunneldioden werden meist direkt in den Halbleiterschichtstapel eingebettet und bestehen oft aus mehr als den zwei zwingend notwendigen n- bzw. p-dotierten Schichten. So werden z. B. Barriereschichten um den p-n Übergang der Tunneldiode angebracht, um die Diffusion der Dotierstoffe aus den hochdotierten Schichten zu unterdrücken [Kojima, N., et al., Analysis of impurity diffusion from tunnel diodes and optimization for operation in tandem cells. Solar Energy Materials and Solar Cells, 1998, 50(1-4): p. 237-42]. Außerdem können durch Barriereschichten mit höherer Bandlücke oder niedriger Dotierung auch Potentialtöpfe neben dem Tunnelübergang generiert werden wodurch eine resonante Interband-Tunneldiode erzeugt entsteht [Niu Jin, et al., 151 kA/cm2 peak current densities in Si/SiGe resonant interband tunneling diodes for high-power mixed-signal applications. Applied Physics Letters, 2003, 83 (16) : p. 3308].

Alle Halbleiterschichten der Tunneldioden sollten in der Regel gitterangepasst zu den umliegenden Halbleitermaterialien abgeschieden werden. Obwohl die Schichten normal dünner als die kritische Schichtdicke sind, können diese durch Kristallverspannung Fadenversetzungen generieren, welche in die Teilzellen hinein reichen und den Wirkungsgrad der Solarzellenstruktur stark verringern [Guter, W., et al. Investigation and Development of III-V Triple-Junction Concentrator Solar Cells. in Proceedings of the 22nd European Photovoltaic Solar Energy Conference and Exhibition. 2007, Milan, Italy]. In heutigen III-V Mehrfachsolarzellen oder anderen optoelektronischen Bauteilen werden Tunneldioden deshalb so gut wie möglich gitterangepasst zu den umgebenden Halbleiterschichten abgeschieden.

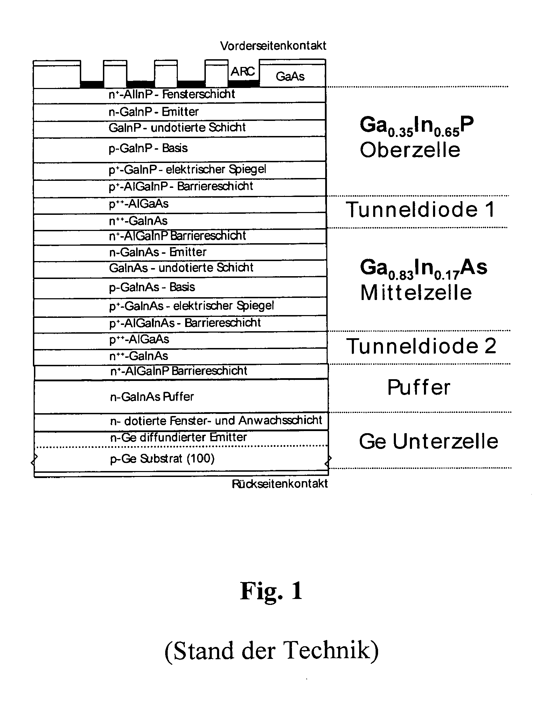

In den letzten Jahren hat sich neben dem gitterangepassten Wachstum verschiedener Halbleiterschichten aufeinander zunehmend das metamorphe Abscheiden von Halbleiterschichten etabliert [Dimroth, F., et al., Metamorphic GayIn1-yP/Ga1-xInxAs Tandem Solar Cells for Space and for Terrestrial Concentrator Applications at C > 1000 Suns. Progress in Photovoltaics: Research and Applications, 2001. 9(3): p. 165-1 78]. Um eine bessere Anpassung der einzelnen Teilsolarzellen einer Tripelzelle ans Sonnenspektrum zu erreichen wird zwischen der untersten Zelle aus Germanium beispielsweise ein Puffer hergestellt, der die Gitterkonstante vergrößert. In dieser Pufferschicht entsteht durch die Fehlanpassung ein dichtes Versetzungsnetzwerk. Eine wichtige Aufgabe eines solchen Puffers ist aber auch, dass diese Versetzungen nicht in die photoaktiven Teile des Zellstapels vordringen, sondern im Puffer lokalisiert bleiben. Figur 1 veranschaulicht den Schichtaufbau einer metamorphen Tripelsolarzelle. Nachdem auf das Ge-Substrat eine gitterangepasste Fensterschicht aufgebracht wurde, wird die Gitterkonstante in einem GaInAs Puffer durch einen ansteigenden In-Gehalt vergrößert. Danach werden Tunneldioden gitterangepasst zu den Schichten der GaInAs Mittelzelle und zur obersten Schicht des Puffers abgeschieden. Alle Schichten nach dem Puffer sind weitgehend gitterangepasst zueinander.

Eine Erweiterung des Konzepts ist die invertierte metamorphe Tripelsolarzelle. Dabei werden die einzelnen Halbleiterschichten zum einen in umgekehrter Reihenfolge beispielsweise auf einem GaAs Substrat abgeschieden, welches danach entfernt wird [Geisz, I. F., et al. Inverted GaInP/(In)GaAs/InGaAs Triple-Junction Solar Cells with Low-Stress Metamorphic Bottom Junctions. in Proceedings of the 33rd IEEE PVSC. 2008. San Diego]. Um noch freier in der Wahl der einzelnen Teilsolarzellen zu sein, können auch zwischen allen Teilzellen oben beschriebene Pufferstrukturen eingesetzt werden. Dadurch kann jede Teilzelle eine andere Gitterkonstante besitzen. Alle Schichten zwischen den Pufferstrukturen sind jedoch gitterangepasst zueinander. Das gilt auch für die Tunneldioden, die sich über oder unter der Teilzelle befinden [Geisz, I. F., et al. Inverted GaInP/(In)GaAs/InGaAs Triple-Junction Solar Cells with Low-Stress Metamorphic Bottom Junctions. in Proceedings of the 33rd IEEE PVSC. 2008. San Diego].

### Nachteile Stand der Technik

Die Randbedingung der Gitteranpassung ist eine starke Einschränkung an einsetzbaren Materialkombinationen. Um hochtransparente Tunneldioden herzustellen, würde man gerne hochbandlückige, indirekte und sehr dünne Halbleiterschichten dafür verwenden. Um eine hohe Tunnelstromdichte zu realisieren, würde man gerne hochdotierte, niedrigbandlückige Halbleiterschichten verwenden, die einen optimalen Halbleiterheteroübergang ausbilden (Typ III). Es ist sofort klar, dass für die Bandlücke ein Kompromiss aus Transparenz und Tunnelstromdichte eingegangen werden muss. Umso wichtiger ist es, die anderen Halbleitereigenschaften, wie indirekte Bandlücke der p-dotierten Schicht und hohe Dotierung, zu realisieren. Dabei wird es schwierig, die Gitteranpassung einzuhalten. Wird die Gitterkonstante der Halbleiterschichten in der Tunneldiode zu klein oder zu groß gewählt, baut sich selbst bei dünnen nur leicht verspannten Schichten genug Spannung auf, um Kristalldefekte zu generieren, die auch in umliegende Halbleiterschichten hinein reichen. Dabei muss die Dicke der Tunneldiodenschichten nicht einmal die kritische Schichtdicke überschreiten.

In gitterangepassten Tripelsolarzellen auf Ge ist man deshalb im Wesentlichen auf (AlₓGa₁₋ₓ)_{0.99}In_{0.01}As und (AlₓGa₁₋ₓ)_{0.5}In_{0.5}P beschränkt. Da in metamorphen Tripelzellen die Teilzellen aus GaInAs mit bis zu 40% In und aus GaInP mit bis zu 65% In bestehen ist man in diesem je nach Material auch auf AlGaInAs mit Indium-Gehalten bis zu 40% und AlGaInP mit Indium-Gehalten bis zu 65% beschränkt. Insbesondere der Einsatz von indirekten Halbleitermaterialien mit niedriger Bandlücke und von Halbleitergrenzflächen mit Typ III Heteroübergang ist so nur eingeschränkt möglich. Ein höherer Kohlenstoffgehalt in AlGaInAs reduziert zusätzlich dessen Gitterkonstante, was z.B. durch einen höheren Indiumgehalt ausgeglichen werden kann.

Durch den hohen Indium Gehalt in AlGaInAs bei metamorphen Strukturen, sind diese Schichten schwieriger p-dotierbar. Kohlenstoffhalogene, wie Kohlenstofftetrabromid (CBr₄), reduzieren den Indium Einbau, so dass keine Gitteranpassung der Schicht möglich ist [Guter, W., et al. Investigation and Development of III-V Triple-Junction Concentrator Solar Cells. in Proceedings of the 22nd European Photovoltaic Solar Energy Conference and Exhibition. 2007, Milan, Italy]. Bei intrinsischer Dotierung mit Kohlenstoff aus den organischen Gruppen der Metallorganika ist ein Großteil des eingebauten Kohlenstoffs nicht elektrisch aktiv, weil er mit Wasserstoff passiviert ist [Oda, Y., et al., Suppression of hydrogen passivation in carbon-doped GaAsSb grown by MOCVD. Journal of Crystal Growth, 2004. 261(2-3): p. 393-397]. In diesem Fall muss also ein Kompromiss zwischen Gitteranpassung und Dotierung eingegangen werden. Entweder wird eine gitterfehlangepasste Tunneldiodenschicht in Kauf genommen, die den Wirkungsgrad der Solarzelle stark reduziert, oder es wird eine niedrige p-Dotierung in Kauf genommen. Dann ist die Zellstruktur aufgrund der Tunneldiode jedoch nicht für hoch-konzentrierende Photovoltaik Systeme geeignet.

Nach dem heutigen Stand der Technik ist es nicht möglich Tunneldioden mit sehr hohen Tunnelströmen in metamorphen Strukturen herzustellen. In der Vergangenheit wurden oft fehlangepasste Schichten hingenommen. Diese generieren Kristalldefekte, welche den Wirkungsgrad der Solarzellenstruktur verringern.

### Darstellung des zu lösenden Problems

Da die Halbleiterschichten der Tunneldioden gitterangepasst an die umliegenden Halbleiterschichten gezüchtet werden müssen, stellt die Gitteranpassung eine strenge Randbedingung an deren Aufbau dar. Obwohl die Schichten der Tunneldiode in der Regel dünn sind, können diese, wenn sie verspannt hergestellt werden, zu Kristalldefekten führen, die bis in die photoaktiven Schichten der Solarzelle reichen und deren Wirkungsgrad reduzieren. Die Forderung von Gitteranpassung schränkt jedoch die Wahl an möglichen Verbindungshalbleiter-Materialien stark ein. Für die Tunneldiode wichtige Eigenschaften, wie hohe Dotierung und passende Bandstruktur können nicht optimal eingestellt werden.

Es ist daher die Aufgabe der vorliegenden Erfindung, die Randbedingung, dass alle Schichten gitterangepasst zueinander hergestellt werden sollen, zu lockern und somit eine größere Materialauswahl speziell aufeinander abgeschiedener Halbleiterschichten zu ermöglichen.

Diese Aufgabe wird bezüglich des Halbleiterbauteils mit den Merkmalen des Patentanspruchs 1, bezüglich einer speziell ausgebildeten Solarzelle mit den Merkmalen des Patentanspruchs 14 sowie Verwendungszwecke des Bauteils mit den Merkmalen des Patentanspruchs 15 gelöst. Die abhängigen Patentansprüche stellen dabei vorteilhafte Weiterbildungen dar.

Erfindungsgemäß wird somit ein Halbleiterbauelement bereitgestellt, enthaltend mindestens eine Schichtfolge aus einer Tunneldiode, die sandwichartig zwischen zwei Halbleiterschichten angeordnet ist, wobei die Tunneldiode mindestens eine entartete n-leitende Schicht sowie eine entartete p-leitende Schicht umfasst, mit der Maßgabe, dass die Schichten jeweils eine Dicke zwischen 10 nm und 100 nm aufweisen und die Gitterkonstanten der Materialien der entarteten Schichten einen Unterschied von mindestens 0,5 % aufweisen.

Die vorliegende Erfindung beschreibt somit Halbleiterbauteile mit Tunneldioden aus spannungskompensierten Halbleiterschichten. Unter Spannungskompensation versteht man die Methode, eine dünne Halbleiterschicht pseudomorph, also elastisch verspannt, abzuscheiden und die entstehende Verspannung durch Kompensation mit einer in die andere Richtung verspannten Schicht zu kompensieren. Erfindungsgemäß wird eine Verspannung durch eine verspannte Schicht mit zu großer Gitterkonstante als ,,kompressiv verspannte Schicht" und eine verspannten Schicht mit einer zu kleinen Gitterkonstanten als ,,tensil verspannte Schicht" bezeichnet, so dass eine tensil verspannte Schicht mit einer kompressiv verspannten Schicht kompensiert wird. Dazu darf bei der jeweiligen Schicht die kritische Schichtdicke, ab dieser Versetzungsbildung einsetzt, nicht überschritten werden. Solche Verfahren werden heute etwa bei der Herstellung von Quantentöpfen eingesetzt. Da Tunneldioden in der Regel aus dünnen Schichten bestehen, kann die Methode der Spannungskompensation auch bei diesem Bauelement angewendet werden. Dies lockert die Forderung nach Gitteranpassung in sofern, als dass nur die Kombination mehrerer Schichten keine Verspannung auslösen soll. Die einzelnen Schichten dürfen allerdings verspannt sein. Die Forderung nach einer gleichbleibenden Gitterkonstanten kann mit diesen spannungskompensierten Tunneldioden gelockert werden. Es dürfen also Materialien mit unterschiedlicher Gitterkonstante verwendet werden, solange die Verspannung durch die Schichten minimiert wird. Dadurch wird die Auswahl an möglichen Halbleitermaterialien zur Herstellung von Tunneldioden deutlich erhöht. Außerdem können die Eigenschaften der Tunneldioden durch verspannte Schichten verbessert werden. Grenzflächenzustände, welche durch lokale Verspannung induziert werden, können beispielsweise die maximale Tunnelstromdichte um ein vielfaches erhöhen. Durch Spannungskompensation werden Kristalldefekte außerhalb der Tunneldioden vermieden.

Erfindungsgemäß ist somit in einer ersten Ausführungsform vorgesehen, dass die Materialien der entarteten Schichten zueinander unterschiedliche Gitterkonstanten aufweisen. Die Differenz der Gitterkonstanten muss dabei mindestens 0,5 % bis max. 5 %, bevorzugt mindestens 1 % bis maximal 2 %, betragen. Werden diese Schichten durch aus dem Stand der Technik bekannten Methoden aufeinander abgeschieden, erfolgt ein Verspannen der Schichten gegeneinander. Wird somit eine Schicht mit größerer Gitterkonstante auf einer Schicht mit kleinerer Gitterkonstante aufgewachsen, so wird das Kristallgitter der Schicht mit der kleineren Gitterkonstante in Wachstumsebene gedehnt. Entsprechend wird das Kristallgitter der Schicht mit der größeren Gitterkonstante komprimiert. Wird beispielsweise eine entartete p-leitende Schicht aus einem Material mit einer größeren Gitterkonstante als das Material der entarteten n-leitenden Schicht auf diese Schicht abgeschieden, so erfolgt ein Verspannen wie vorstehend beschrieben. Für das voranstehende Beispiel, in dem das Material der p-leitenden Schicht eine eigentlich größere Gitterkonstante als das Material der n-leitenden Schicht aufweist, spricht man dann wie vorstehend erläutert von einer kompressiv verspannt abgeschiedenen Schicht. Für den umgekehrten Fall, also beispielhaft für den Fall, dass die Gitterkonstante des Materials einer der entarteten p-leitenden Schicht, die auf einer n-leitenden Schicht abgeschieden werden soll, eine kleinere Gitterkonstante als das Material der n-leitenden Schicht aufweist, wird die so abgeschiedene entartete p-leitende Schicht als tensil verspannte Schicht bezeichnet.

Erfindungsgemäß ist es bei dem Halbleiterbauelement in einer ersten Ausführungsform bevorzugt, wenn die gemittelten Gitterkonstanten der entarteten Schichten im Wesentlichen der Gitterkonstante der Materialien der umgebenden Halbleiterschichten entsprechen. Mit im Wesentlichen ist erfindungsgemäß eine Abweichung der gemittelten Gitterkonstanten der entarteten Schichten zu den umgebenden Halbleiterschichten von bis zu 0,5 % umfasst.

Selbstverständlich umfasst die Erfindung auch eine Ausführungsform, bei der eine Verspannung zwischen einer entarteten Schicht und einer umgebenden Halbleiterschicht realisiert ist.

Die für die entarteten Schichten und umgebenden halbleitenden Schichten in Frage kommenden Materialien können unabhängig voneinander ausgewählt sein aus der Gruppe bestehend aus Ge, Si, SiGe, GaAs, GaSb, GaInP, AlGaAs, GaInAs, GaPN, GaInAsSb, GaInNAs, GaInAsPN, AlGaInP, AlGaInAs, AlGaAsSb, AlGaInP, GaAsSb, AlGaSb, InN, GaAsP und/oder AlGaInNAs. Die Materialien werden dabei so gewählt, dass sie den Anforderungen des Anspruchs 1 genügen, d.h. es werden Materialien gewählt, die eine mindestens um 0,5 % verschiedene Gitterkonstante aufweisen. Die Gitterkonstanten sind dem Fachmann anhand bekannter Diagramme, die den Zusammenhang zwischen den Zusammensetzungen der Halbleiterverbindungen und den Gitterkonstanten beschreiben, bekannt. Insofern ist eine breite Varianz an Materialien möglich. Dies ermöglicht völlig neuartige Solarzellen bzw. eine verbesserte Stromleitung zwischen den Teilsolarzellen, die über eine erfindungsgemäße Tunneldiode verbunden sind.

Vorzugsweise ist die entartete p-leitende Schicht mit Kohlenstoff dotiert, ebenso kann die n-leitende entartete Schicht mit Tellur, Silicium und/oder Germanium dotiert sein.

Mit den erfindungsgemäßen Halbleiterbauteilen, die die erfindungsgemäß definierten Tunneldioden beinhalten, gehen wesentliche Vorteile einher.

Solche Tunneldioden besitzen eine höhere Tunnelstromdichte und erlauben den Einsatz der Solarzelle auch in hochkonzentrierenden Photovoltaiksystemen. Durch spannungskompensierte Schichten in der Tunneldiode lassen sich auch Halbleiterübergänge aus weiteren Materialien realisieren, die eine bessere Band-Anordnung haben wie zum Beispiel InN/AlGaSb, oder GaSb/InAs, oder GaAs/GaSb. Auch dies erhöht den maximal erreichbaren Tunnelstrom der Tunneldiode.

Konkret kann die tensile Verspannung einer hoch Kohlenstoffdotierten AlGaAs Schicht in der Tunneldiode einer metamorphen Tripelsolarzelle durch eine kompressiv verspannte Schicht, wie GaInAs oder GaInP mit sehr hohen Indiumgehalt, kompensiert werden. Es kann also eine Tunneldiode mit hochdotierten Schichten hergestellt werden, die keine Defekte generiert, welche in die Teilsolarzellen reichen.

Mit spannungskompensierten Tunneldioden ist eine weitgehend transparente Teilzellen-Verbindung mit niedrigem elektrischen Widerstand und geringen Generation von Kristalldefekten außerhalb der Tunneldiode möglich. Außerdem können auch in anderen Solarzellenstrukturen optimalere Materialkombinationen für die Tunneldioden eingesetzt werden, wenn die Gitteranpassung durch die Spannungskompensation als Randbedingung für die Herstellung ersetzt wird.

Die Erfindung umfasst weiterhin auch Halbleiterbauteile, die wie vorstehend beschrieben aufgebaut sind, wobei jedoch die mindestens eine Schichtenfolge zusätzlich mindestens eine Barriereschicht mit einer Schichtdicke von 10 nm bis 100 nm umfasst, wobei die Barriereschicht(en) jeweils zwischen den entarteten Schichten und den umgebenden Halbleiterschichten angeordnet sind.

Es ist dabei vorteilhaft, wenn die umgebenden Halbleiterschichten eine höhere Bandlückenenergie als die entarteten Schichten aufweisen.

Durch diese Ausführungsform sind weitere bevorzugte Aufbauten der Halbleiterbauteile möglich.

Der Vorteil dieser Ausführungsform besteht nun darin, dass eine Spannungskompensation nicht nur zwischen den entarteten Schichten der Tunneldiode, sondern auch noch zwischen den Barriereschichten, die ebenfalls als dünne Schichten ausgebildet sind, und den jeweils angrenzenden entarteten Schichten erreicht werden kann.

Bevorzugt ist das vorstehend beschriebene Halbleiterbauteil in einer ersten Variante dabei so aufgebaut, dass die Gitterkonstanten der Materialien der entarteten Schichten spannungskompensiert und im Wesentlichen gleich der Gitterkonstanten der Halbleiterschichten und der Barriereschichten sind.

Eine weitere Ausführungsform sieht dann vor, dass die Gitterkonstanten der Materialien einer entarteten Schicht der Tunneldiode größer oder kleiner ist als die Gitterkonstante der angrenzenden Barriereschicht. Dadurch sind nun Aufbauten möglich, bei denen die gemittelten Gitterkonstanten der Materialien der entarteten Schicht und der Barriereschicht im Wesentlichen gleich der umgebenden Halbleiterschichten sind. Für die vorstehend beschriebene Ausführungsform mit einer Schichtenfolge, bei der zusätzlichen Barriereschichten vorgesehen sind, kann die Differenz zwischen den Gitterkonstanten der entarteten Schichten und den Barriereschichten wiederum bevorzugt mindestens 0,5 % betragen. Bevorzugt beträgt die Differenz der Gitterkonstanten mindestens 0,5 % bis maximal 5 %, besonders bevorzugt 0,1 % bis maximal 2 %.

Erfindungsgemäß wird ebenso eine Solarzelle bereitgestellt, die mindestens ein zuvor beschriebenes Halbleiterbauteil umfasst.

Verwendungsmöglichkeiten des erfindungsgemäßen Halbleiterbauteils finden sich in der Solartechnik, als Mehrfachsolarzelle, als Laserdiode oder als Leuchtdiode.

Das erfindungsgemäße Konzept wird anhand der nachfolgenden beispielhaften Ausführungen sowie den Figuren näher erläutert, ohne die Erfindung auf die dargestellten Ausführungsformen zu beschränken.

Dabei zeigen
- Figur 1: den schematischen Aufbau einer metamor- phen Tripelsolarzelle gemäß dem Stand der Technik.
- Figur 2: zwei erfindungsgemäße Ausführungsformen eines Halbleiterbauteils.
- Figur 3: eine metamorphe Tripelsolarzelle, die ein Halbleiterbauteil mit zwei erfindungsge- mäßen Tunneldioden umfasst.
- Figur 4: eine weitere Ausführungsform eines Halb- leiterbauteils mit Barriereschichten.
- Figur 5: eine Ausführungsform der Erfindung mit Barriereschichten und Spannungskompensa- tor mit der Barriereschicht.
- Figur 6: eine Abwandlung der Ausführungsform nach Figur 5.
- Figur 7: den Aufbau einer metamorphen Tripelsolar- zelle.

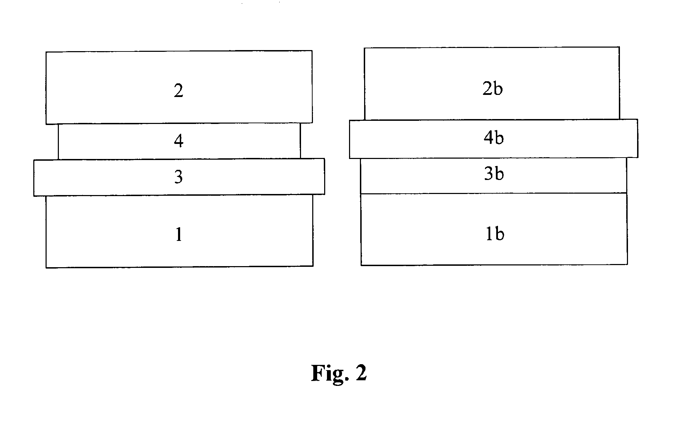

Figur 2 zeigt zwei erfindungsgemäße Schichtabfolgen aus zwei Halbleiterschichten 1 und 2, zwischen die die beiden Schichten 3 und 4 der Tunneldiode sandwichartig eingeschlossen sind. Die unterschiedliche in den Figuren angedeutete Breite der jeweiligen Schichten repräsentiert dabei die originäre Gitterkonstante der jeweils für die Schichten verwendeten Materialien. In der linken Ausführungsform des erfindungsgemäßen Halbleiterbauteils der Figur 2 weist somit das Material der Schicht 3 eine bezüglich der Schicht 1 größere Gitterkonstante auf (kompressiv verspannt), während die Gitterkonstante des Materials der Schicht 4 kleiner als die Gitterkonstante des Materials 3 ist (tensil verspannt). Das Material der Schicht 2 weist eine ungefähr gleich große Gitterkonstante auf, wie das Material, das für Schicht 1 verwendet wird. Im Fall des Halbleiterbauteils der linken Ausführungsform der Figur 2 ist somit sowohl die Schicht 3 verspannt auf der Schicht 1 als auch die Schicht 4 verspannt auf der Schicht 3. Dadurch wird eine Spannungskompensation mit der Schicht 3, 4 erreicht, deren gemittelte Gitterkonstante in etwa der der Halbleiterschicht entspricht.

In der rechten Ausführungsform der Figur 2 weist das für die Schicht 3 der Tunneldiode verwendete Material eine ungefähr gleich große Gitterkonstante auf wie das für die Schicht 1 des Halbleiterverbundes verwendete Material. Verspannungen treten hierbei somit beim Übergang der Schicht 3 auf Schicht 4 sowie von Schicht 4 auf Schicht 2 auf. Dabei weist das Material für Schicht 4 eine größere Gitterkonstante auf, als die für die Schichten 3 bzw. 2 verwendeten Materialien.

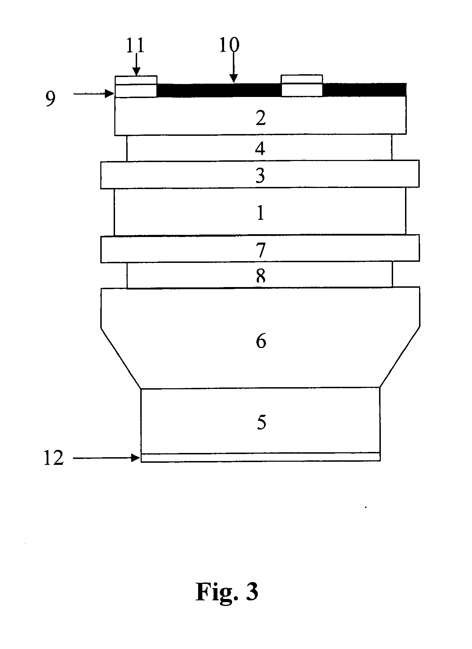

Figur 3 zeigt ein mögliches Ausführungsbeispiel eines spannungskompensierten Halbleiterbauteils in einer metamorphen Tripel-Solarzellenstruktur mit GaInP O-berzelle 2, GaInAs Mittelzelle 1, GaInAs Pufferstruktur 6 und Ge-Substrat 5. Für die spannungskompensierten Tunneldiodenschichten können beispielsweise GaInAs 3 und AlGaAs 4 bzw. AlGaAsSb 7 und GaAs 8 verwendet werden. Dazu kommen eine hoch dotierte Cap-Schicht 9, eine Antireflexionsschicht 10, ein Vorderseitenkontakt 11 und ein Rückseitenkontakt 12. Auch hier wird die Gitterkonstante durch eine unterschiedliche Breite der Kästchen veranschaulicht.

Alternativ muss die Solarzellenstruktur nicht metamorph sein. Dann wird eine Pufferschicht 6 nicht unbedingt benötigt und die jeweiligen Indium-Gehalte der Teilzellen sind je nach Substrat anders. Entsprechend muss auch die Schichtdicke der spannungskompensierten Tunneldioden angepasst werden.

Des Weiteren könnten auch andere Materialien für die Teilzellen der Mehrfachsolarzelle, die Pufferschicht oder die Tunneldiodenschichten verwendet werden. Zum Beispiel AlGaInP 2, AlGaInAs 1 und GaInNAs 5 oder die Tunneldioden werden in Zweifach- Vierfach oder Fünffach-Zellen eingesetzt. Bei der Fünffach-Zelle könnten die Teilzellen beispielsweise aus AIGaInP, GaInP, AlGaInAs, GaInAs, und Ge bestehen.

Außerdem kann die spannungskompensierte Tunneldiode auch in anderen optoelektronischen Bauteilen, wie Laser (VCSEL mit Tunnelkontakt), Leuchtdioden oder isolierten Tunneldioden eingesetzt werden.

Die einzelnen Schichten der Tunneldiode bestehen bevorzugt aus kompressiv verspanntem AlGaInAs und tensil verspanntem AlGaInAs, aus kompressiv verspanntem AlGaInP und tensil verspanntem AlGaInP, aus kompressiv verspanntem AlGaInAs und tensil verspanntem AlGaInP oder aus kompressiv verspanntem AlGaInP und tensil verspanntem AlGaInAs.

Die spannungskompensierte Tunneldiode kann in Tandemsolarzellen mit zwei p-n-Übergängen aus GaInP und Ga(In)As, aus Ga(In)As und Ge oder aus AlGa(In)As und Ga(In)As verwendet werden. Die spannungskompensierte Tunneldiode kann ebenso in Tripelsolarzellen mit drei p-n-Übergängen aus GaInP, GaInAs und Ge, aus AlGaInAs, GaInAs und Ge, aus AlGaInP und GaInAs und Ge, verwendet werden. Ebenso ist eine Tripelsolarzelle mit der spannungskompensierten Tunneldiode mit drei p-n-Übergängen aus GaInP, GaAs und GaInAs oder aus AlGaInP, GaAs und GaInAs möglich. Die spannungskompensierte Tunneldiode kann auch in Vierfachsolarzellen mit vier p-n-Übergängen aus (Al)GaInP, (Al)GaInAs, (Al)GaInNAs, und Ge verwendet werden. Weiterhin ist die spannungskompensierte Tunneldiode in Fünf- oder Sechsfachsolarzellen mit fünf oder sechs p-n-Übergängen aus AlGaInP, GaInP, AlGaInAs, GaInAs, und GaInNAs und/oder Ge verwendbar.

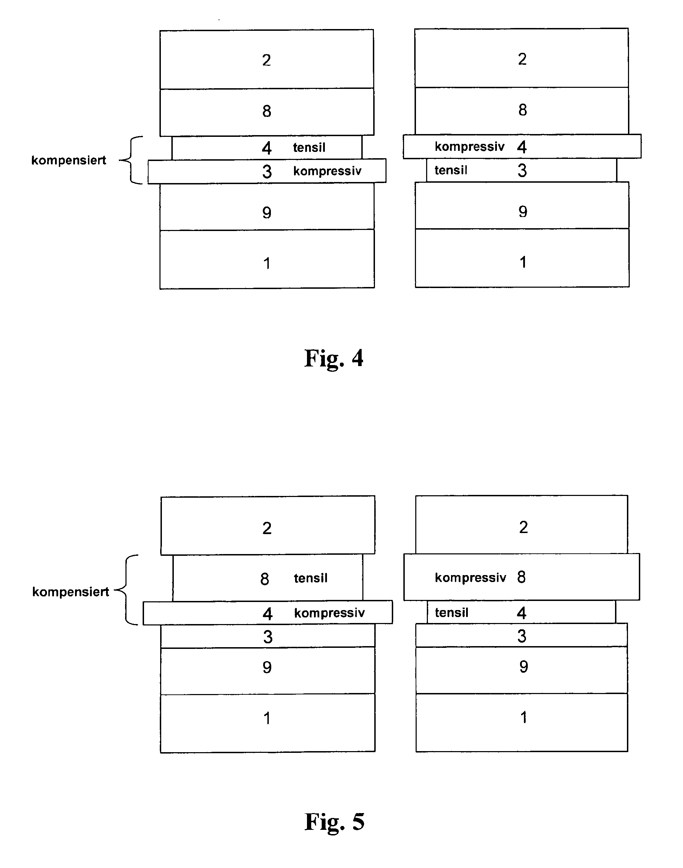

Figur 4 zeigt nun analog schematisch im Aufbau wie Figur 2 den erfindungsgemäßen Aufbau eines Halbleiterbauteils.

Die in Figur 4, linker Teil dargestellte Ausführungsform zeigt nun ein Beispiel, bei dem zusätzlich Barriereschichten 8, 9 zwischen den entarteten Schichten 3, 4 und den Halbleiterschichten 1, 2 angeordnet sind.

Bei der Ausführungsform nach Figur 4, linker Teil ist nun der Aufbau der entarteten Schichten 3, 4 so gewählt worden, dass eine Schicht, im Beispielsfall hier die Schicht 3, eine größere Gitterkonstante aufweist als die Schicht 4, was symbolisch durch die größere Breite veranschaulicht ist, so dass die Schicht 3 kompressiv verspannt ist. Die Schicht 4 wird tensil-verspannt aufgewachsen um die Spannungskompensation zu realisieren. Die gemittelten Gitterkonstanten dieser Schichten entsprechen nun im Wesentlichen den Gitterkonstanten der Materialien der halbleitenden Schichten 1, 2.

Genauso ist natürlich eine Ausführungsform möglich, bei der die p-leitende Schicht 4 kompressiv, d.h. eine größere Gitterkonstante aufweist und die n-leitende entartete Schicht 3 eine kleinere Gitterkonstante und somit tensil-verspannt ist, so dass aber im Ergebnis wiederum die gemittelten Gitterkonstanten der Materialien der Schichten 3 und 4 im Wesentlichen den Gitterkonstanten der halbleitenden Schichten 1, 2 entsprechen.

In Figur 5 ist nun eine weitere Ausführungsform dargestellt, bei der eine Spannungskompensation zwischen den Tunneldiodenschichten und den Barriereschichten realisiert ist. Im Beispielsfall nach Figur 5, linker Teil ist dabei die entartete p-leitende Schicht 4 kompressiv-verspannt, d.h. sie weist eine größere Gitterkonstante als die angrenzende Schicht 3 auf. Entscheidend ist nun, dass die gemittelten Gitterkonstanten der Schichten 4 und 8 nun wiederum den Gitterkonstanten der Materialien der umgebenden halbleitenden Schichten 1, 2 entsprechen. Im Ergebnis ist somit die Schicht 8 tensil und die andere Schicht 4 kompressiv verspannt.

Im rechten Teil ist nun ein umgekehrter Aufbau gewählt, d.h. hier ist die Barriereschicht 8 kompressiv und die p-leitende entartete Schicht 4 tensil-verspannt. Im Ergebnis erfolgt aber auch hier wieder im Vergleich zu den umgebenden Halbleiterschichten 1, 2 eine Anpassung der Gitterkonstanten.

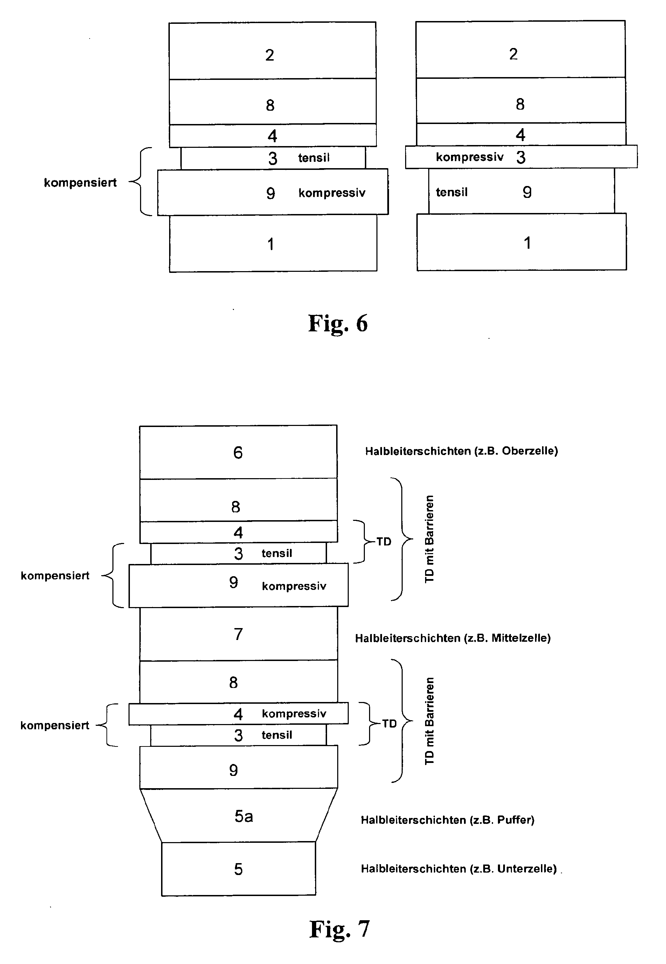

Letztlich zeigt Figur 6 noch eine weitere Möglichkeit, wie ein erfindungsgemäßes Halbleiterbauteil aufgebaut sein kann. Auch hier wird wiederum eine Spannungskompensation nun hier zwischen den Tunneldiodenschichten 3 und den Barriereschichten 9 erreicht. Im linken Teil der Figur 6 ist nun die Schicht 3 tensil und die Schicht 9 kompressiv verspannt, wohingegen im rechten Teil die Schicht 9 tensil und die Schicht 3 kompressiv verspannt ist, wobei hier wieder im Vergleich zu den umgebenden Halbleiterschichten 1, 2, wenn die gemittelten Materialkonstanten ermittelt werden, eine Angleichung hergestellt wird.

Figur 7 zeigt nun ein Anwendungsbeispiel in einer metamorphen Tripelsolarzelle. Die Schichten 5 und/oder 6 können dabei auch aus mehreren Halbleiterschichten bestehen und ggf. eine Solarzelle bilden. Die Barriereschichten 8, 9 der unteren Tunneldiode sowie die Barriereschicht 8 der oberen Tunneldiode sind optional. Barriereschicht 9 der oberen Tunneldiode wird in diesem Fall zur Spannungskompensation verwendet. Kompensation bedeutet, dass die mittlere Gitterkonstante der verspannten Schichten den umliegenden Halbleiterschichten entspricht. Dies gilt auch im Falle von metamorphen Strukturen, wo die umliegenden Halbleiterschichten 1, 2 und 7 gemeint sind und nicht die Schichten 5 und/oder 5a, die eine andere bzw. eine undefinierte Gitterkonstante aufweisen.

## Patentansprüche

1. Halbleiterbauteil, enthaltend mindestens eine Schichtfolge aus einer Tunneldiode, die sandwichartig zwischen zwei Halbleiterschichten (1, 2) angeordnet ist, wobei die Tunneldiode mindestens eine entartete n-leitende Schicht (3) sowie eine entartete p-leitende Schicht (4) umfasst, mit der Maßgabe, dass die Schichten (3, 4) jeweils eine Dicke zwischen 10 nm und 100 nm aufweisen und die Gitterkonstanten der Materialien der entarteten Schichten (3, 4) einen Unterschied von mindestens 0,5 % aufweisen.

2. Halbleiterbauteil nach Anspruch 1, **dadurch gekennzeichnet, dass** die Differenz zwischen den Gitterkonstanten mindestens 0,5 % bis maximal 5 %, bevorzugt mindestens 1 % bis maximal 2 % beträgt.

3. Halbleiterbauteil nach Anspruch 1 oder 2, **dadurch gekennzeichnet, dass** die gemittelte Gitterkonstante der entarteten Schichten (3, 4) im Wesentlichen der Gitterkonstante der Materialien der Halbleiterschichten (1, 2) entspricht.

4. Halbleiterbauteil nach einem der vorhergehenden Ansprüche, **dadurch gekennzeichnet, dass** die Versetzungsrelaxation der Schichten (3, 4) maximal 50 % beträgt.

5. Halbleiterbauteil nach einem der vorhergehenden Ansprüche, **dadurch gekennzeichnet, dass** die Schichtmaterialien der Schichten (1, 2, 3) und/oder (4) unabhängig voneinander ausgewählt sind aus der Gruppe bestehend aus Ge, Si, SiGe, GaAs, GaSb, GaInP, AlGaAs, GaInAs, GaPN, GaInAsSb, GaInNAs, GaInAsPN, AlGaInP, AlGaInAs, AlGaAsSb, AlGaInP, GaAsSb, AlGaSb, InN, GaAsP und/oder AlGaInNAs.

6. Halbleiterbauteil nach einem der vorhergehenden Ansprüche, **dadurch gekennzeichnet, dass** die p-leitende Schicht (4) mit Kohlenstoff und/oder die n-leitende Schicht (3) mit Tellur, Silicium und/oder Germanium dotiert ist.

7. Halbleiterbauteil nach einem der vorhergehenden Ansprüche, **dadurch gekennzeichnet, dass** die Tunneldiode mindestens eine Schichtenfolge Barriereschichten (8, 9) mit einer Schichtdicke von 10 nm bis 100 nm umfasst, wobei die Barriereschichten (8, 9) zwischen den entarteten Schichten (3, 4) und den Halbleiterschichten (1, 2) angeordnet sind.

8. Halbleiterbauteil nach einem der vorhergehenden Ansprüche, **dadurch gekennzeichnet, dass** Schicht (9) eine höhere Bandlückenenergie als Schicht (3) und/oder Schicht (8) eine höhere Bandlückenenergie als Schicht (4) aufweist.

9. Halbleiterbauteil nach Anspruch 8, **dadurch gekennzeichnet, dass** die gemittelten Gitterkonstanten der Materialien der entarteten Schichten (3, 4) im Wesentlichen gleich der Gitterkonstanten der Materialien der Halbleiterschichten (1, 2) sind.

10. Halbleiterbauteil nach Anspruch 8, **dadurch gekennzeichnet, dass** die Gitterkonstanten der Materialien der entarteten Schicht (3, 4) größer oder kleiner ist als die Gitterkonstanten der Materialien der Barriereschicht (8, 9).

11. Halbleiterbauteil nach Anspruch 10, **dadurch gekennzeichnet, dass** die gemittelten Gitterkonstanten der Materialien der entarteten Schicht (3, 4) und der Barriereschicht (8, 9) im Wesentlichen gleich der Gitterkonstanten der Materialien der halbleitenden Schichten (1, 2) sind.

12. Halbleiterbauteil nach einem der vorhergehenden Ansprüche, **dadurch gekennzeichnet, dass** die Schichten (1) und/oder (2)
a) Halbleitermaterialien mit p-n-Übergang sind, oder
b) Halbleitermaterialien ohne p-n-Übergang sind, an die sich jeweils mindestens eine weitere Halbleiterschicht anschließt, die bevorzugt einen p-n-Übergang aufweist.

13. Halbleiterbauteil nach einem der vorhergehenden Ansprüche, **dadurch gekennzeichnet, dass** sich an die Schichten (1) und/oder (2) iterativ mindestens eine weitere Tunneldiode sowie an die weitere Tunneldiode mindestens eine weitere Schichtfolge anschließt.

14. Solarzelle, enthaltend mindestens ein Halbleiterbauteil nach einem der vorhergehenden Ansprüche.

15. Verwendung eines Halbleiterbauelements nach einem der Ansprüche 1 bis 13 als Solarzelle, Mehrfachsolarzelle, Laserdiode oder Leuchtdiode.
